# EUROPEAN PATENT SPECIFICATION

(11) **EP 1 120 484 B1**
(45) Date of publication and mention of the grant of the patent: **11.02.2009**
(21) Application number: 00101771.4
(22) Date of filing: 27.01.2000
(51) Int. Cl.: C30B 15/10, C30B 35/00

(54) **Carbon fiber reinforced carbon composite and useful as components for pulling single crystal apparatus**
Kohlenfaserstoffverstärktes Kohlenstoff-Material und seine Verwendung in Bauteilen einer Einkristallziehungsanlage
Matériau composite de carbone renforcé par la fibre de carbone et son utilisation dans des éléments d'un appareil de tirage de monocristaux

(43) Date of publication of application: 01.08.2001
(73) Proprietor: TOYO TANSO CO., LTD., Osaka-shi, Osaka 555-0011 (JP)
(72) Inventor: Toshiharu, Hiraoka, c/o Toyo Tanso Co., Ltd., Mitoyo-gun, Kagawa 769-1612 (JP); Naoto, Ohta, c/o Toyo Tanso Co., Ltd., Mitoyo-gun, Kagawa 769-1612 (JP); Akira, Asari, c/o Toyo Tanso Co., Ltd., Osaka-shi, Osaka 555-0011 (JP); Toshiaki,Sogabe, c/o Toyo Tanso Co., Ltd., Mitoyo-gun, Kagawa 769-1612 (JP)
(74) Representative: TBK-Patent

(56) References cited:
- EP-A- 0 913 504
- FR-A- 2 757 182
- US-A- 5 616 175
- PATENT ABSTRACTS OF JAPAN vol. 1998, no. 11, 30 September 1998 (1998-09-30) & JP 10 158090 A (NIPPON CARBON CO LTD), 16 June 1998 (1998-06-16)
- PATENT ABSTRACTS OF JAPAN vol. 1998, no. 08, 30 June 1998 (1998-06-30) & JP 10 059795 A (TOYO TANSO KK), 3 March 1998 (1998-03-03)

## Description

### Technical Field

The present invention is directed to a carbon fiber reinforced carbon composite (C/C composite). More particularly, the present invention is directed to the C/C composite with impregnated and coated pyrolytic carbon.

### Background of the Invention

Size of pulling single crystal apparatus for Czochralski (CZ) method have been a recent trend towards increasing with increasing diameter of the single crystal. The structural elements of using under high temperature atmosphere have been used a high-density and a high-purity isotropic graphite with high mechanical properties under high temperature. The size of the graphite elements is also increasing with the CZ apparatus. This produces a handling problem caused by the increased weights for the existing graphite elements and a problem of reduction in effective processing size of the inside of the apparatus.

The C/C composite has many excellent properties of lightweight and strong mechanical strength, as compared with the graphite material. By virtue of this, even when reducing in thickness, the structural elements of the C/C composite can have a strength equal to those of the graphite material, to enable an effective use of a processing chamber of the apparatus. In addition, by virtue of being lightweight, a good handling can be achieved in, for example, placement in the apparatus. By virtue of these, the crucible components used in the CZ apparatus having a large diameter are now moving from those made of the graphite to those made of the C/C composite.

However, the C/C composite has large specific surface area and large diameter of pores. Accordingly, the C/C composite is reacting with SiO gas in the apparatus easily and reacting rate to silicon carbide (SiC) is faster than the graphite.

The inventors have proposed the C/C composite with impregnated and coated pyrolytic carbon (PyC) by CVI (Chemical Vapor Infiltration) for a crucible of the CZ apparatus in PCT W097-49844 in order to prevent reacting with SiO gas. The case of the C/C composite with the impregnated and the coated PyC by CVI, the impregnated PyC layer is formed deep, but the coated PyC layer is formed thin. Consequently, the C/C composite can not prevent to react with SiO gas and to form SiC. The case of the C/C composite with the impregnated and the coated PyC by only CVD (Chemical Vapor Deposition), the coated PyC layer is formed thick, but the impregnated PyC layer is formed shallow. Consequently, the C/C composite can prevent to react with Si0 gas, but when the coated PyC on the surface is worn out, the C/C composite is going to change to SiC due to the impregnated PyC layer is thin. Accordingly, the C/C composite with the impregnated and the coated PyC by CVD has safety problems for applied to the pulling single crystal apparatus.

JP-A-10158090 discloses a graphite crucible having an inner/outer double structure, wherein the crucible consists of a C/C-material on the outer side of the crucible and an isotropic graphite material is formed on the inner side of the crucible.

In JP-A-10059795 a method of producing a crucible is described, in which a fibrous material consisting of carbon fibers is impregnated with a resin, the resulting body is heated and hardened, then carbonized and the carbonized material is re-impregnated, carbonized and heat-treated again.

FR-A-2 757 182 refers to a method for growing an alkali halide crystal in a graphite crucible which has a surface depth region of its inside surface which is impregnated with glassy carbon so as to eliminate porosity.

In the objective of the present invention to provide the C/C composite with high resistance of reacting to SiC by impregnating and coating PyC by CVI and CVD continuously and a pulling single crystal apparatus of the C/C composite.

The present invention therefore provides a C/C composite, comprising of: impregnating selected from a pitch and a resin into a molded member formed of carbon fibers for densification; forming a impregnated PyC layer by CVI after subjected to the densification; and forming a coated PyC layer continuously on the impregnated PyC layer by CVD without taken out from the furnace after CVI. The molded member can be carried out high purification under halogen gas atmosphere at 2,000 to 2,500°C before CVI. A density difference between the impregnated layer and the coated layer of PyC of the C/C composite is not more than 0.2 g/cm³, and more preferably 0.1 g/cm³. A thickness of the coated PyC layer is 10 to 100 µm, more preferably 20 to 80 µ m. An average surface roughness of the coated PyC layer is not more than 5 µm.

The surfaces of the CVD coated PyC can be formed very smooth due to the gap of the carbon fibers on the surface are filled with the impregnated PyC by CVI. According to the density difference between the impregnated layer and the coated layer of PyC of the C/C composite is not more than 0.2 g/cm³, and more preferably 0.1 g/cm³, the resistance of the delaminating of the PyC coated layer is increasing due to the definite boundary of the impregnated layer and coated layer is disappeared. According to the thickness of the coated PyC layer is 10 to 100 µm, more preferably 20 to 80 µm, the C/C composite can be prevented penetrating SiO gas into inside. Furthermore, according to the average surface roughness of the coated PyC layer is not more than 5 µm, the C/C composite can be prevented reacting to SiC due to the contact surface area with SiO gas is decreasing.

The impregnated PyC layer and the coated PyC layer are formed continuously by CVD after CVI in the same furnace without taken off from furnace after CVI. Accordingly, the clear boundary between the impregnated PyC layer and the coated PyC layer is not appeared, and there are no impurities in the boundary of the impregnated PyC layer and the coated PyC layer due to never exposing in the air.

The present invention therefore provides a pulling single crystal apparatus made from the high purity C/C composite with high resistance of reacting to SiC by the impregnated and coated PyC by CVI and CVD continuously.

### Brief Description of the Drawing

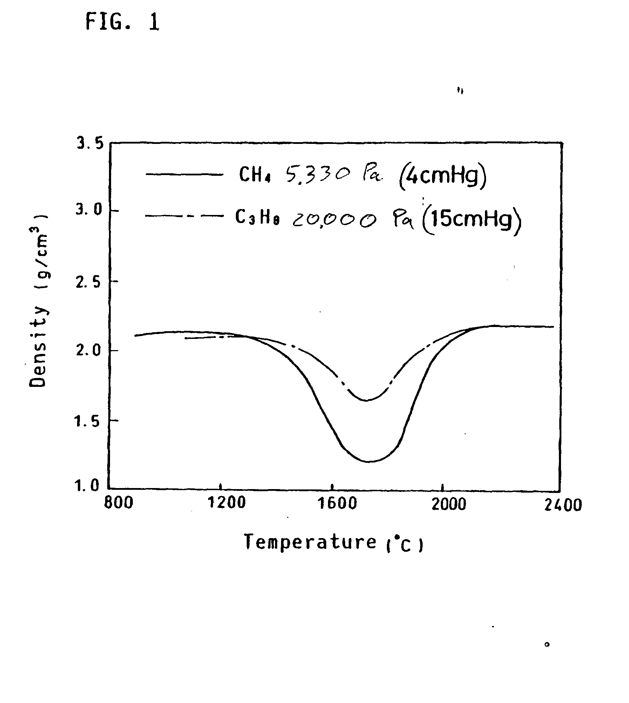

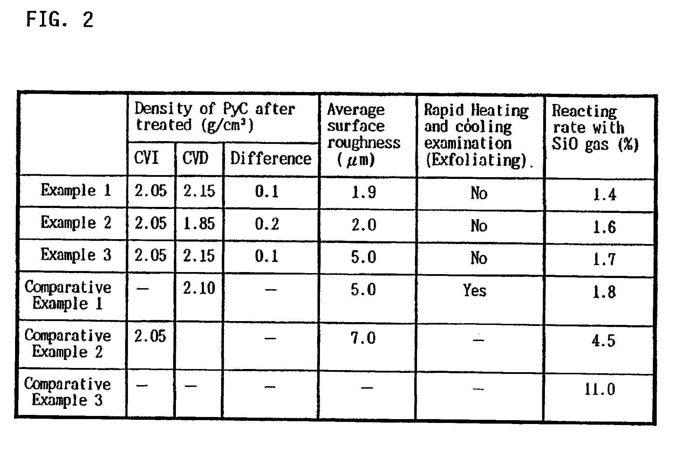

FIG. 1 is a relationship between deposition temperature and density of pyrolytic carbon.

### Detailed Description of the Preferred Embodiments

The C/C composite of the present invention, for example, the starting carbon fibers may be used UD (Uniaxial Dimension) or 2-D (2 directional Dimensions) carbon fibers of pitch or polyacrylonitrile (PAN). Then, the carbon fibers are heated up for solidification after laminating prepreg with impregnated a resin or molding member by filament winding to form a member. Also 3-D or n -D cloth of impregnated with the resin are heated up to form a member. When the laminating, the carbon fibers of contacting with quartz crucible layer are forming 1K cloth which is high density and fine filament better than a 3K cloth for protecting oxidation when SiO gas penetrate into inside. The primary molded member obtained is heated under an inert gas to be subjected to a primary carbonization. Further, a pitch and/or a resin impregnation and a carbonization are repeated a required number of times to densify the primary molded member by impregnation. When obtaining a required density, the primary molded member is heat-treated to subject to a graphitization at high temperature. The carbon fibers can be high purified under a halogen gas atmosphere before the densification. And then the primary molded member is subjected to high purification under a halogen gas atmosphere at about 2,000 to 2,500°C. The high purification can be carried out with graphitization at same time and same furnace. Also, the high purification and the graphitization can be carried out separate. Also a pitch and/or a resin can be impregnated for densification at same time.

Then, fine pores in the surface of the molded member are impregnated with PyC by CVI for the objective of preventing to react with SiO gas. The impregnated PyC by CVI are provided 10 to 100 1/min flow of hydrocarbons or hydrocarbon compounds gas which have number of 1 to 8 carbons at 800 to 1,300 C under 1.33 to 13.3 kPa. In the CVI, keeping time can be controlled to required forming thickness of the impregnated PyC. The impregnated PyC layer plays a part in the buffer layer for protecting of the coated PyC layer delaminating from substrate, and having a thickness of 5 to 20 µm, more preferably 5 to 10 µm in order to protect from forming SiC in coated surface layer. The carbon structure of CVI impregnated layer is mainly fine RC (Rough Columnar) structure which is like needle.

Then, the surface coated layer of PyC is formed by CVD in order to protect penetrating SiO gas into inside. The CVD process is carried out higher temperature and lower pressure than the CVI process in order to higher deposition rate. It is known that density of the deposited carbon is increasing to ideal density with higher deposition temperature, but production cost also increases with higher process temperature. This is against the objective of the invention. Therefore, the CVD conditions in which are temperature of 1,500 to 2,200 °C, pressure of 0.13 to 1.33 kPa, keeping time of 50 to 100 hours and hydrocarbon of 1 to 8 carbons gas flow of 5 to 50 1/min may be control to form required thickness. The coated layer is delaminating when it is too thick. When the coated layer is too thin, it can not be prevented SiO gas permeating into the inside. Because of the thickness of the coated layer is needed 10 to 100 µm, more preferably 20 to 80 µm in order to prevent forming SiC. Controlling CVD temperature can control the crystal structure of the coated PyC on the surface. Accordingly, coefficient of thermal radiation can be having 0.45 to 0.75 compared with ideal black body by controlling the crystal structure of the PyC.

The surface roughness of the CVD coated PyC is not more than 5 µm, more preferably not more than 4 µm due to the gap of the carbon fibers on the surface are filled with the impregnated PyC by CVI.

Therefore, the surface can be protected forming to SiC due to the decreasing contact surface area with SiO gas.

The density and structure of the PyC of forming the impregnated layer and the coated layer can be changed by production conditions as heating rate, substrate temperature, and gas concentration as gas type and gas flow rate. FIG. 1 (Chemistry and Physics of Carbon, Vol.5, P.47) shows the relationship between PyC density at room temperature and PyC deposition temperature for example. As shown in FIG. 1, the density of PyC at temperature range of 800 to 1,300 °C is about 2.2 g/cm³, at temperature range of 1,300 to 1,700 °C is decreasing and then increasing again at temperature over than 1,700 °C to 2.2 g/cm³ which is close to ideal density of carbon. This is based on multiplier effect with the nuclear deposition rate and the growing rate. The nuclear deposition rate and growing rate are increasing with higher temperature.

The other words, at the high temperature stage, the PyC are having high density because of the nuclear of the PyC are growing up and formatting same direction on the substrate. At low temperature stage, the PyC is also having high density because of the PyC nuclear are depositing and accumulating on the substrate before growing up due to the substrate temperature is not enough temperature for growing up of the PyC nuclear. At middle temperature stage, the PyC density is decreasing and then increasing again because of the PyC nuclear are depositing and accumulating before nuclear of the accumulated on the substrate growing up and formatting same direction. Accordingly, it is main factor for PyC formation that the nuclear accumulating on the substrate at low temperature stage and the nuclear of accumulated on the substrate growing up and formatting same direction at high temperature stage.

In the invention, the fine grain and the high density PyC is impregnated at low temperature and then the large grain and high density PyC is coated at high temperature, continuously. The resistance of the delaminating of the PyC coated layer can be increasing due to the density of the impregnated layer and the coated layer being same when impregnating and coating. The density controlling is controlled impregnating and coating conditions as furnace temperature and gas concentration as gas flow and pressure.

The boundary of the impregnated layer and the coated layer is appeared when CVI and CVD carried out separately. For example, it is when a condition in each treatment was carried out without taking the formation mechanism of the PyC into consideration, and it is when installed again in CVD furnace and CVD was carried out after taken out for a while from the furnace and exposed in the air. An impurities in the air adsorb on the surface of CVI layer when taken out from the furnace and exposed in the air after CVI, it is causes that abnormal growth, unregularly formatting on the substrate and preventing growth of the PyC nuclear while CVD treatment by the impurities left in the surface. It can be considered one of the causes which the boundary of the impregnated layer and the coated layer appears on clearly. When the boundary appeared, the coated layer where it was formed in the surface by CVD is delaminating and cracking easily by thermal shock and so on. Therefore, half cuts the effect even if the impregnated layer and the coated layer are formed. Therefore, the impregnating and the coating treatment can be done adjusting the conditions and continuously in the same furnace in order to forming CVI and CVD layers which have same structure and the density difference within 0.2 g/cm³ without clearing the boundary. Accordingly, the PyC of extreme outside layer of the impregnated layer where it was formed by CVI can be nuclear in CVD treatment without obstructing of impurities, and can be forming new CVD coating layer.

And, it becomes possible from before that the thickness of the impregnated layer and the coated layer is taken thickly to do CVI and CVD carried out continuously. Because of the delaminating of the coated layer is hard. And the surface roughness of the C/C composite can control by CVI and CVD conditions though it depends on how to form it and the kind of the fiber which forms the C/C composite.

And then, specific surface area of the surface can be made small by making surface roughness not more than 5 µm. In other words, a contact area with the air on the surface can become small, and can be improve to prevent the forming to SiC. Furthermore, the simplification of the process and the stabilization of the quality can be done by CVI and CVD continuously. And, the high temperature member for single crystal pulling apparatus formed with the C/C composite, which has excellent to prevent the forming to SiC, can be provided.

While the present invention is described below more specifically with reference to the following examples, embodiments of the present invention are by no means limited to the following examples.

### (Example 1)

A layer of a plain weave cloth of carbon fibers (6K, made by TORAY INDUSTRIES, INC.) impregnated with phenol resin was laminated, thereafter, the molded member was solidification by increasing the temperature of the oven up to 200 °C for 10 hours. Then, the molded member was increased in temperature up to 1,000°C under nitrogen atmosphere at the heating ratio of 10 °C/hr in an electric oven, to obtain the C/C composite. Further, the molded member was subjected to a pitch impregnation process for densification and then was increased in temperature up to 1,000°C at the heating ratio of 10°C/hr in the electric oven with nitrogen flow for baking. The baking process was repeated three times. Further, the molded member was heated up to 2,000°C. Thereafter, the molded member was machined into 60 × 10 × 3 mm. After the machining process, the member was further high purified at 2,000°C for 50 hours under normal pressure of halogen gas atmosphere. And then, for the purpose of being impregnated pyrolytic carbon by CVI, the molded member was set in a vacuum furnace into which CH₄ gas was supplied 10 1/min and to keep for 100 hours under the pressure of 1.33 kPa at 1,100°C. After CVI, for the purpose of being coated pyrolytic carbon on CVI impregnated layer by CVD, the molded member was heated up to 2,000°C continuously in the same furnace and decreased pressure to 0.5 kPa with 5 l/min of CH₄ gas flow for keeping time of 3 hours.

The sample is 1.9 µm of the average surface roughness and 50 µm of the coating thickness.

### (Example 2)

Except the CVD temperature of 1,800 °C, this Example is all the same as Example 1. The sample is 2.0 µm of the average surface roughness and 50 µm of the coating thickness.

### (Example 3)

A layer of a plain weave cloth of PAN carbon fibers (T-300 6K, made by TORAY INDUSTRIES, INC.) impregnated with phenol resin was laminated on a mandrel, followed by application of the filament windings thereon. In the filaments windings, with six filaments of T-300 12K (Made by TORAY INDUSTRIES, INC.) whose ash contents is 76 ppm in the ash content determined method were impregnating with phenol resin, the level winding and the parallel winding of a contact angle of 85 ° to 90° with respect to the center axis were alternately wound 5 layers each. While the drum is allowed to have 10 layers of the alternate parallel and level windings, the bottom is allowed to have the layers of the level windings only. As a result of this, the molded member having a thickness of layer of 10 mm was obtained. Subsequently, the volatile matter of the obtained molded member was adjusted in an oven at 100°C and, thereafter, the molded member was solidification by increasing the temperature of the oven up to 200°C. After having been solidification, the molded member was removed from the mandrel to obtain the molded member. Then, the molded member was increased in temperature up to 1,000°C under nitrogen atmosphere at the heating ratio of 10°C/hr in an electric oven, to obtain the C/C composite. Further, the molded member was heated up to 2,000°C for 10 hours under halogen gas atmosphere for the high purification process. Further, the molded member was subjected to a pitch impregnation process for densification and then was increased in temperature up to 1,000°C at the heating ratio of 10°C/hr in the electric oven with nitrogen flow for baking. The baking process was repeated twice. Further, the molded member was heated up again to 2,000°C under normal pressure of halogen gas atmosphere for the graphitization and the high purification process. Thereafter, the molded member was impregnated PyC by CVI as same conditions of Example 1. After CVI, the molded member was heated up to 1,800°C continuously in the same furnace and decreased pressure to 0.5 kPa with 5 l/min of CH₄ gas flow for keeping time of 3 hours.

The sample is 5.0 µm of the average surface roughness and 50 µm of the coating thickness.

### (Comparative Example 1)

Except without CVI, this Example is all the same as Example 1. The sample is 5.0 µm of the average surface roughness and 10 µm of the coating thickness.

### (Comparative Example 2)

Except without CVD, this Example is all the same as Example 1. The sample is 7.0 µm of the average surface roughness.

### (Comparative Example 3)

Except without CVI and CVD, this Example is all the same as Example 1.

The samples of the Example 1 - 3 and the Comparative Example 1 - 3 were installed with the metal silicone in the vacuum furnace, and a reacting examination was done at 1, 800 °C under 13.3 kPa for 5 hours. After the reacting examination, a change in weight of each sample was measured and calculating the reacting rate with the SiO gas.

Furthermore, the samples of the Example 1 - 3 and the Comparative Example 1 and 2 were examined a rapid heating and rapid cooling examination. In other words, the sample which heated up to 1,000 °C in 5 min was thrown in the water, and cooled rapidly, and the delaminating conditions of the PyC were examined. The number of the samples is five respectively.

The results of the reacting rate with the SiO gas, the rapid heating and rapid cooling examination and the density of the after each of CVI and CVD were shown in TABLE I. The density of the PyC was calculated by degree of orientation which was calculated from specific intensity of [002] surface of carbon by X-ray diffraction.

The samples of the Example 1 - 3 which were density difference between the impregnated layer and the coated layer have excellent delaminating resistance and low reacting rate with the SiO gas, as shown in TABLE I. The average surface roughness of the sample of the Example 3 was rougher than the sample of the Example 1 and 2, and according this, the reacting rate with the SiO gas is high because of the average surface roughness is high. The surface of the sample of the Comparative Example 1 delaminated as a result of the rapid heating and rapid cooling examination, because of the surface of the sample of the Comparative Example 1 was formed by only CVD. The sample of the Comparative Example 2 was high reacting rate with SiO gas as compared with the samples of the Example 1-3, because of the sample of the Comparative Example 2 was formed PyC layer by only CVI.

## Claims

1. A carbon fiber reinforced carbon composite, obtainable by a manufacturing method comprising of:
(1) impregnating selected from a pitch and a resin into a molded member formed of carbon fibers for densification;
(2) forming a impregnated pyrolytic carbon layer by CVI after subjected to the densification; and
(3) forming a coated pyrolytic carbon layer on the impregnated pyrolytic carbon layer by CVD.

2. A carbon fiber reinforced carbon composite according to Claim 1, wherein the molded member formed of carbon fibers, after subjected to the densification, are subjected to a high purification process.

3. A carbon fiber reinforced carbon composite according to Claim 1, wherein density difference between the impregnated pyrolytic carbon layer and the coated pyrolytic carbon layer is not more than 0.2 g/cm³

4. A carbon fiber reinforced carbon composite according to Claim 1, wherein thickness of the coated pyrolytic carbon layer is 10 to 100 µm.

5. A carbon fiber reinforced carbon composite according to Claim 1, wherein average surface roughness of the coated pyrolytic carbon layer is not more than 5 µm.

6. A manufacturing method of a carbon fiber reinforced carbon composite, comprising of:
(1) impregnating selected from a pitch and a resin into a molded member formed of carbon fibers for densification;
(2) forming a impregnated pyrolytic carbon layer by CVI after subjected to the densification; and
(3) forming a coated pyrolytic carbon layer on the impregnated pyrolytic carbon layer continuously by CVD in the same furnace of the CVI.

7. A manufacturing method of a carbon fiber reinforced carbon composite according to Claim 6, wherein the molded member formed of carbon fibers, after subjected to the densification, are subjected to a high purification process.

8. A manufacturing method of a carbon fiber reinforced carbon composite according to Claim 6, wherein density difference between the impregnated pyrolytic carbon layer and the coated pyrolytic carbon layer is not more than 0.2 g/cm³.

9. A manufacturing method of a carbon fiber reinforced carbon composite according to Claim 6, wherein thickness of the coated pyrolytic carbon layer is 10 to 100 µm.

10. A manufacturing method of a carbon fiber reinforced carbon composite according to Claim 6, wherein average surface roughness of the coated pyrolytic carbon layer is not more than 5 µm.

11. A pulling single crystal apparatus made from a carbon fiber reinforced carbon composite, obtainable by a manufacturing method comprising of:
(1) impregnating selected from a pitch and a resin into a molded member formed of carbon fibers for densification;
(2) forming a impregnated pyrolytic carbon layer by CVI after subjected to the densification; and
(3) forming a coated pyrolytic carbon layer on the impregnated pyrolytic carbon layer by CVD.

12. A pulling single crystal apparatus made from a carbon fiber reinforced carbon composite according to Claim 11, wherein the molded member formed of carbon fibers, after subjected to the densification, are subjected to a high purification process.

13. A pulling single crystal apparatus made from a carbon fiber reinforced carbon composite according to Claim 11, wherein density difference between the impregnated pyrolytic carbon layer and the coated pyrolytic carbon layer is not more than 0.2 g/cm³.

14. A pulling single crystal apparatus made from a carbon fiber reinforced carbon composite according to Claim 11, wherein thickness of the coated pyrolytic carbon layer is 10 to 100 µm.

15. A pulling single crystal apparatus made from a carbon fiber reinforced carbon composite according to Claim 11, wherein average surface roughness of the coated pyrolytic carbon layer is not more than 5 µm.

## Patentansprüche

1. Kohlefaser-verstärktes Kohlenstoffkomposit, erhältlich durch ein Herstellungsverfahren, umfassend:
(1) Imprägnieren, mit einem ausgewählt aus einem Pech und einem Harz, eines aus Kohlefasern gebildeten, geformten Elements zum Verdichten;
(2) Bilden einer imprägnierten, pyrolytischen Kohlenstoffschicht durch CVI, nachdem der Verdichtung unterworfen; und
(3) Bilden einer beschichteten, pyrolytischen Kohlenstoffschicht auf der imprägnierten, pyrolytischen Kohlenstoffschicht durch CVD.

2. Kohlefaser-verstärktes Kohlenstoffkomposit nach Anspruch 1, wobei das aus Kohlefasern gebildete, geformte Element, nachdem der Verdichtung unterworfen, einem Hochreinigungsverfahren unterworfen wird.

3. Kohlefaser-verstärktes Kohlenstoffkomposit nach Anspruch 1, wobei der Dichteunterschied zwischen der imprägnierten, pyrolytischen Kohlenstoffschicht und der beschichteten, pyrolytischen Kohlenstoffschicht nicht mehr als 0,2 g/cm³ beträgt.

4. Kohlefaser-verstärktes Kohlenstoffkomposit nach Anspruch 1, wobei eine Dicke der beschichteten, pyrolytischen Kohlenstoffschicht 10 bis 100 µm beträgt.

5. Kohlefaser-verstärktes Kohlenstoffkomposit nach Anspruch 1, wobei eine gemittelte Oberflächenrauheit der beschichteten, pyrolytischen Kohlenstoffschicht nicht mehr als 5 µm beträgt.

6. Verfahren zur Herstellung eines Kohlefaser-verstärkten Kohlenstoffkomposits, umfassend:
(1) Imprägnieren, mit einem ausgewählt aus einem Pech und einem Harz, eines aus Kohlefasern gebildeten, geformten Elements zum Verdichten;
(2) Bilden einer imprägnierten, pyrolytischen Kohlenstoffschicht durch CVI, nachdem der Verdichtung unterworfen; und
(3) kontinuierliches Bilden einer beschichteten, pyrolytischen Kohlenstoffschicht auf der imprägnierten, pyrolytischen Kohlenstoffschicht durch CVD in demselben Ofen des CVI.

7. Verfahren zur Herstellung eines Kohlefäserverstärkten Kohlenstoffkomposits nach Anspruch 6, wobei das aus Kohlefasern gebildete, geformte Element, nachdem der Verdichtung unterworfen, einem Hochreinigungsverfahren unterworfen wird.

8. Verfahren zur Herstellung eines Kohlefaser-verstärkten Kohlenstoffkomposits nach Anspruch 6, wobei ein Dichteunterschied zwischen der imprägnierten, pyrolytischen Kohlenstoffschicht und der beschichteten, pyrolytischen Kohlenstoffschicht nicht mehr als 0,2 g/cm³ beträgt.

9. Verfahren zur Herstellung eines Kohlefaser-verstärkten Kohlenstoffkomposits nach Anspruch 6, wobei eine Dicke der beschichteten, pyrolytischen Kohlenstoffschicht 10 bis 100 µm beträgt.

10. Verfahren zur Herstellung eines Kohlefaser-verstärkten Kohlenstoffkomposits nach Anspruch 6, wobei eine gemittelte Oberflächenrauheit der beschichteten, pyrolytischen Kohlenstoffschicht nicht mehr als 5 µm beträgt.

11. Vorrichtung zum Einkristallziehen, hergestellt aus einem Kohlefaser-verstärkten Kohlenstoffkomposit, erhältlich durch ein Herstellungsverfahren, umfassend:
(1) Imprägnieren, mit einem ausgewählt aus einem Pech und einem Harz, eines aus Kohlefasern gebildeten, geformten Elements zum Verdichten;
(2) Bilden einer imprägnierten, pyrolytischen Kohlenstoffschicht durch CVI, nachdem der Verdichtung unterworfen; und
(3) Bilden einer beschichteten, pyrolytischen Kohlenstoffschicht auf der imprägnierten, pyrolytischen Kohlenstoffschicht durch CVD.

12. Vorrichtung zum Einkristallziehen, hergestellt aus einem Kohlefaser-verstärkten Kohlenstoffkomposit nach Anspruch 11, wobei das aus Kohlefasern gebildete, geformte Element, nachdem der Verdichtung unterworfen, einem Hochreinigungsverfahren unterworfen wird.

13. Vorrichtung zum Einkristallziehen, hergestellt aus einem Kohlefaser-verstärkten Kohlenstoffkomposit nach Anspruch 11, wobei ein Dichteunterschied zwischen der imprägnierten, pyrolytischen Kohlenstoffschicht und der beschichteten, pyrolytischen Kohlenstoffschicht nicht mehr als 0,2 g/cm³ beträgt.

14. Vorrichtung zum Einkristallziehen, hergestellt aus einem Kohlefaser-verstärkten Kohlenstoffkomposit nach Anspruch 11, wobei eine Dicke der beschichteten, pyrolytischen Kohlenstoffschicht nicht mehr als 10 bis 100 µm beträgt.

15. Vorrichtung zum Einkristallziehen, hergestellt aus einem Kohlefaser-verstärkten Kohlenstoffkomposit nach Anspruch 11, wobei eine gemittelte Oberflächenrauheit der beschichteten, pyrolytischen Kohlenstoffschicht nicht mehr als 5 µm beträgt.

## Revendications

1. Composite de carbone renforcé avec de la fibre de carbone, pouvant être obtenu par un procédé de fabrication comprenant :
(1) une imprégnation choisie parmi un brai et une résine en un élément moulé formé de fibres de carbone pour densification ;
(2) la formation d'une couche de carbone pyrolytique imprégnée par infiltration chimique en phase vapeur après soumission à la densification ; et
(3) la formation d'une couche de carbone pyrolytique déposée sur la couche de carbone pyrolytique imprégnée par dépôt chimique en phase vapeur.

2. Composite de carbone renforcé avec de la fibre de carbone selon la revendication 1, dans lequel l'élément moulé formé de fibres de carbone, après soumission à la densification, est soumis à un procédé de haute purification.

3. Composite de carbone renforcé avec de la fibre de carbone selon la revendication 1, dans lequel la différence de densité entre la couche de carbone pyrolytique imprégnée et la couche de carbone pyrolytique déposée n'est pas supérieure à 0,2 g/cm³.

4. Composite de carbone renforcé avec de la fibre de carbone selon la revendication 1, dans lequel l'épaisseur de la couche de carbone pyrolytique déposée est 10 à 100 µm .

5. Composite de carbone renforcé avec de la fibre de carbone selon la revendication 1, dans lequel la rugosité de surface moyenne de la couche de carbone pyrolytique déposée n'est pas supérieure à 5 µm.

6. Procédé de fabrication d'un composite de carbone renforcé avec de la fibre de carbone comprenant :
(1) une imprégnation choisie parmi un brai et une résine en un élément moulé formé de fibres de carbone pour densification ;
(2) la formation d'une couche de carbone pyrolytique imprégnée par infiltration chimique en phase vapeur après soumission à la densification ; et
(3) la formation d'une couche de carbone pyrolytique déposée sur la couche de carbone pyrolytique imprégnée de façon continue par dépôt chimique en phase vapeur dans le même four que celui de l'infiltration chimique en phase vapeur.

7. Procédé de fabrication d'un composite de carbone renforcé avec de la fibre de carbone selon la revendication 6, dans lequel l'élément moulé formé de fibres de carbone, après soumission à la densification, est soumis à un procédé de haute purification.

8. Procédé de fabrication d'un composite de carbone renforcé avec de la fibre de carbone selon la revendication 6, dans lequel la différence de densité entre la couche de carbone pyrolytique imprégnée et la couche de carbone pyrolytique déposée n'est pas supérieure à 0,2 g/cm³.

9. Procédé de fabrication d'un composite de carbone renforcé avec de la fibre de carbone selon la revendication 6, dans lequel l'épaisseur de la couche de carbone pyrolytique déposée est 10 à 100 µm.

10. Procédé de fabrication d'un composite de carbone renforcé avec de la fibre de carbone selon la revendication 6, dans lequel la rugosité de surface moyenne de la couche de carbone pyrolytique déposée n'est pas supérieure à 5 µm.

11. Appareil de tirage de monocristaux constitué d'un composite de carbone renforcé avec de la fibre de carbone pouvant être obtenu par un procédé de fabrication comprenant :
(1) une imprégnation choisie parmi un brai et une résine en un élément moulé formé de fibres de carbone pour densification ;
(2) la formation d'une couche de carbone pyrolytique imprégnée par infiltration chimique en phase vapeur après soumission à la densification ; et
(3) la formation d'une couche de carbone pyrolytique déposée sur la couche de carbone pyrolytique imprégnée par dépôt chimique en phase vapeur.

12. Appareil de tirage de monocristaux constitué d'un composite de carbone renforcé avec de la fibre de carbone selon la revendication 11, dans lequel l'élément moulé formé de fibres de carbone, après soumission à la densification, est soumis à un procédé de haute purification.

13. Appareil de tirage de monocristaux constitué d'un composite de carbone renforcé avec de la fibre de carbone selon la revendication 11, dans lequel la différence de densité entre la couche de carbone pyrolytique imprégnée et la couche de carbone pyrolytique déposée n'est pas supérieure à 0,2 g/cm³.

14. Appareil de tirage de monocristaux constitué d'un composite de carbone renforcé avec de la fibre de carbone selon la revendication 11, dans lequel l'épaisseur de la couche de carbone pyrolytique déposée est 10 à 100 µm.

15. Appareil de tirage de monocristaux constitué d'un composite de carbone renforcé avec de la fibre de carbone selon la revendication 11, dans lequel la rugosité de surface moyenne de la couche de carbone pyrolytique déposée n'est pas supérieure à 5 µm.
